# EUROPEAN PATENT SPECIFICATION

(11) **EP 2 876 803 B1**
(45) Date of publication and mention of the grant of the patent: **18.10.2017**
(21) Application number: 13820032.4
(22) Date of filing: 30.05.2013
(51) Int. Cl.: H02M 7/00, H05K 7/12, H05K 7/14

(54) **INVERTER DEVICE**
UMRICHTERVORRICHTUNG
DISPOSITIF ONDULEUR

(30) Priority: 20.07.2012 JP 2012161861
(43) Date of publication of application: 27.05.2015
(73) Proprietor: Fuji Electric Co., Ltd., Kawasaki-shi Kanagawa 210-9530 (JP)
(72) Inventor: SHINTANI, Takanori, Kawasaki-shi Kanagawa 210-9530 (JP)
(74) Representative: Appelt, Christian W.
(86) International application number: PCT/JP2013/065041
(87) International publication number: WO 2014/013798

(56) References cited:
- JP-A- H05 145 268
- JP-A- H11 346 085
- JP-A- 2008 125 248
- JP-A- 2008 131 698
- JP-A- 2009 175 376

## Description

### Technical Field

The present invention relates to an inverter device, and more particularly, to an inverter device including a cylindrical ferrite core, disposed in a manner such that a wire passes through a hollow portion of the ferrite core, in a condition in which the ferrite core is housed in a housing recess portion of a case body.

### Background Art

Heretofore, an inverter device which receives alternating current power from a commercial alternating current power supply, converts the alternating current power to alternating current power of an optical frequency and voltage, and outputs the alternating current power, thereby driving a load, is known. As this kind of inverter device, the one including ferrite cores in order to reduce the noise from wires connecting terminals is proposed (for example, refer to PTL 1).

### Citation List

### Patent Literature

PTL 1: JP-A-2008-125248

### Summary of Invention

### Technical Problem

Meanwhile, although not specified in the heretofore described PTL 1, it is common that the ferrite cores are mounted in a housing recess portion of a case body configuring the inverter device by using a clamping band such as being called a so-called INSULOK (a registered trademark).

Because of this, a clamping band is necessary to house the ferrite cores, and it is necessary to mount the individual ferrite cores using such a clamping band, thus causing an increase in cost due to an increase in the number of parts and in mounting man-hour.

The invention, bearing in mind the heretofore described circumstances, has for its object to provide an inverter device wherein it is possible to achieve a reduction in cost by reducing the number of parts and a mounting man-hour.

### Solution to Problem

In order to achieve the heretofore described object, the invention relates to an inverter device which includes a cylindrical ferrite core, disposed in a manner such that a wire passes through a hollow portion of the ferrite core, in a condition in which the ferrite core is housed in a housing recess portion of a case body. The inverter device according to the invention is characterized by including a support piece, extending in a manner such as to project from one housing side portion configuring the housing recess portion, which, with its own elastic resilience, supports the ferrite core between a housing bottom portion configuring the housing recess portion and the housing side portion; a first projecting portion, formed in a manner such as to project from the housing bottom portion, which abuts against one portion of one edge face of the ferrite core; and a second projecting portion, formed in a manner such as to project from the support piece, which abuts against one portion of the other edge face of the ferrite core.

Also, the invention is such that the inverter device is characterized in that the support piece includes a first support portion extending from the housing side portion in an extension direction of the housing bottom portion; and a second support portion extending from the extension end portion of the first support portion in a direction toward the housing bottom portion.

Also, the invention is such that the inverter device is characterized in that the first projecting portion is formed throughout a portion in the extension direction of the housing bottom portion, and abuts against one portion of one edge portion of the ferrite core in a condition in which an opening of the hollow portion at the one edge portion is opened.

Also, the invention is such that the inverter device is characterized in that the second projecting portion is formed throughout a portion in an extension direction of the first support portion, and abuts against one portion of the other edge portion of the ferrite core in a condition in which an opening of the hollow portion at the other edge portion is opened.

### Advantageous Effects of Invention

According to the invention, a support piece extending in a manner such as to project from one housing side portion configuring a housing recess portion clamps a ferrite core between a housing bottom portion and the housing side portion, and a first projection portion formed in a manner such as to project from the housing bottom portion abuts against one portion of one edge face of the ferrite core, while a second projecting portion formed in a manner such as to project from the support piece abuts against one portion of the other edge face of the ferrite core, whereby it is possible to hold the ferrite core in a condition in which the movement of the ferrite core in a front-rear direction, an up-down direction, and a left-right direction is restricted. Moreover, as there is no need for a clamping band or the like, as heretofore known, and it is only necessary to utilize the elastic resilience of the support piece, it is possible to reduce the number of parts and reduce a mounting man-hour. Consequently, the effect that it is possible to achieve a reduction in cost by reducing the number of parts and a mounting man-hour is produced.

### Brief Description of Drawings

[Fig. 1] Fig. 1 is a perspective view showing an inverter device which is an embodiment of the invention.
[Fig. 2] Fig. 2 is a front view showing the inverter device which is the embodiment of the invention.
[Fig. 3] Fig. 3 is a sectional view along the line A-A in Fig. 2.
[Fig. 4] Fig. 4 is an illustration showing a case in which a housing recess portion shown in Fig. 3 is seen from the front.
[Fig. 5] Fig. 5 is a sectional view along the line B-B in Fig. 4.
[Fig. 6] Fig. 6 is an illustration for illustrating a function of ferrite cores shown in Fig. 3.

### Description of Embodiments

Hereafter, a detailed description will be given, referring to the accompanying drawings, of a preferred embodiment of an inverter device according to the invention.

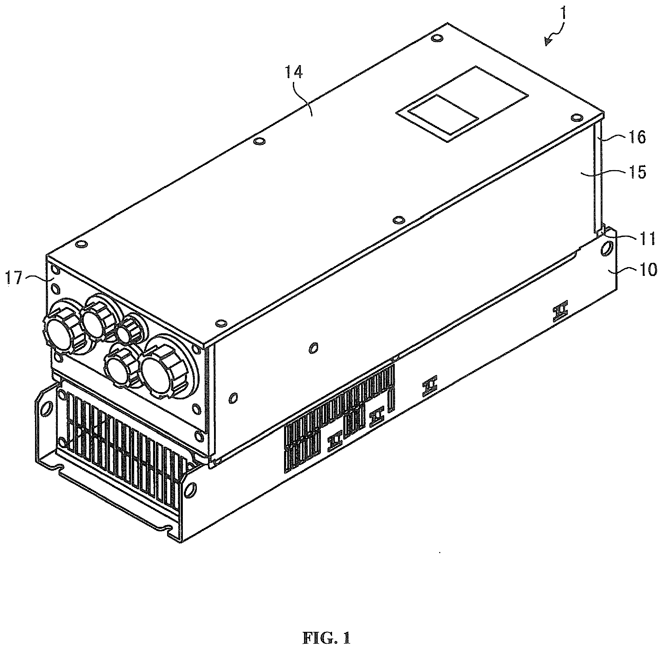

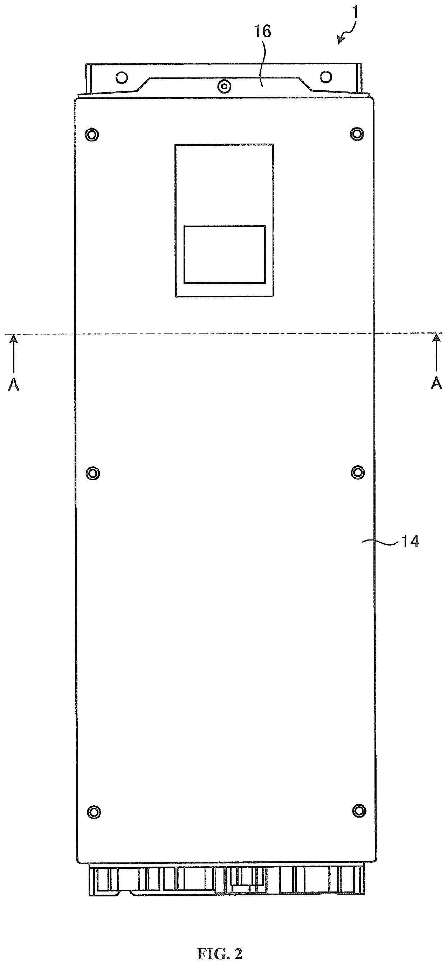

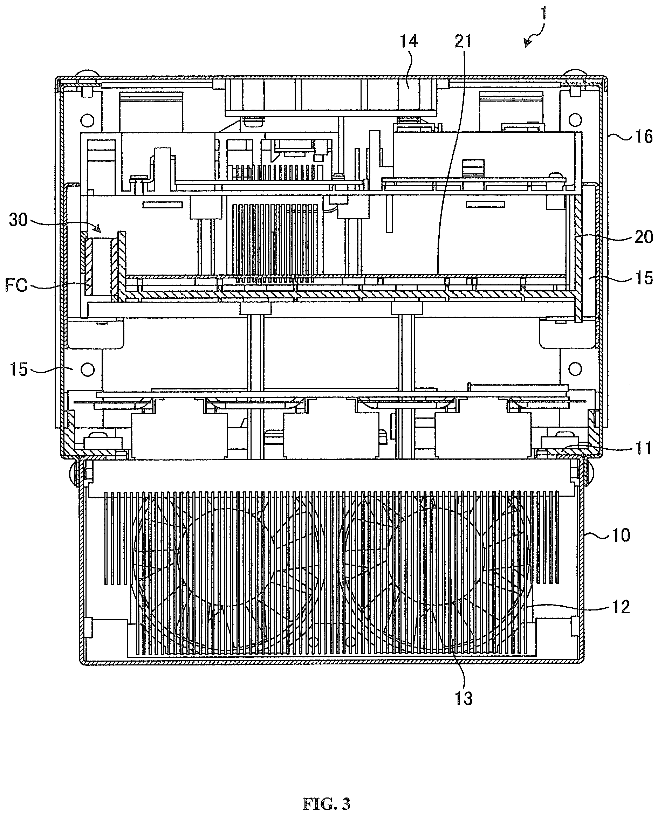

Figs. 1 to 3 each show an inverter device which is the embodiment of the invention, wherein Fig. 1 is a perspective view, Fig. 2 is a front view, and Fig. 3 is a sectional view along the line A-A in Fig. 2. An inverter device 1 illustrated here converts alternating current power supplied from a commercial power supply to alternating current power of a desired frequency and voltage, and outputs the alternating current power.

In this kind of inverter device 1, cooling fins 12, a cooling fan 13, and a direct current reactor (not shown) are housed in space enclosed by a frame 10 and a rear surface cover 11, while various control circuits are housed in space enclosed by the rear surface cover 11, a front surface cover 14, a pair of left and right side covers 15, a top plate 16, and a bottom plate 17.

Further, in this kind of inverter device 1, a ferrite core FC is housed in a housing recess portion 30 of a resin power supply case (case body) 20, as shown in Fig. 3. Herein, the power supply case 20 is for supporting a power supply printed circuit board 21 configuring the control circuits.

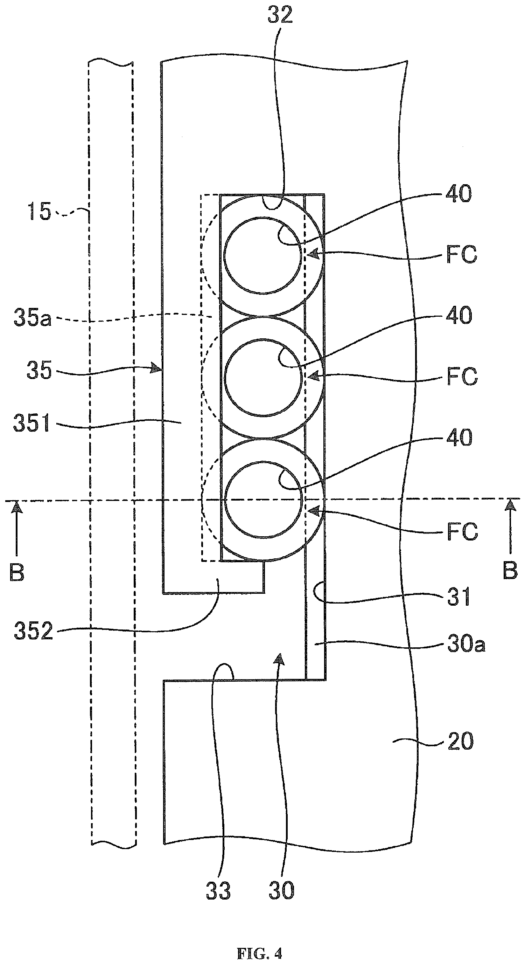

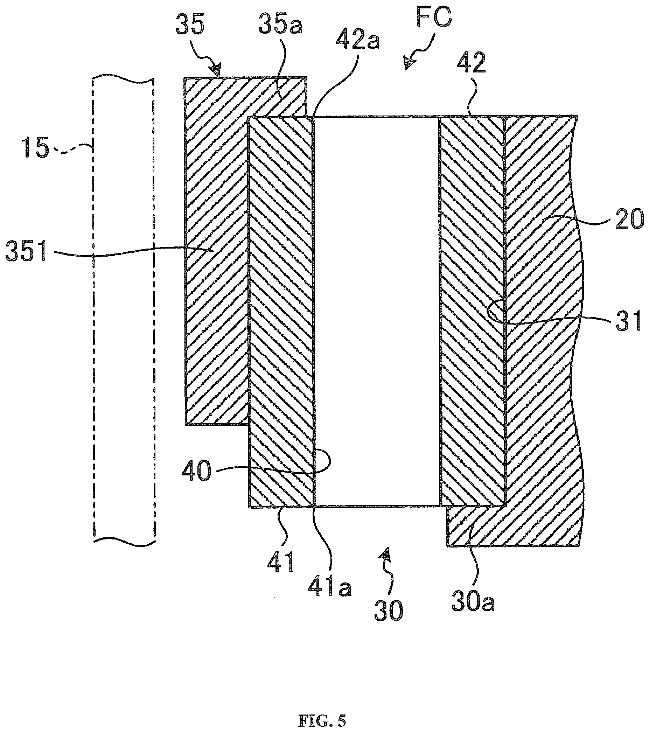

Fig. 4 is an illustration showing a case in which the housing recess portion shown in Fig. 3 is seen from the front, and Fig. 5 is a sectional view along the line B-B in Fig. 4.

As shown in Figs. 4 and 5, the housing recess portion 30, being provided in one portion of a side portion of the power supply case 20, is configured by a housing bottom portion 31 extending in an up-down direction, an upper end side housing side portion 32 extending sideward (leftward) from the upper end portion of the housing bottom portion 31, and a lower end side housing side portion 33 extending sideward (leftward) from the lower end portion of the housing bottom portion, being formed continuously. The lower end side housing side portion 33 pairs with the upper end side housing side portion 32 in a top-to-bottom relationship, and the inner surface of the lower end side housing side portion 33 is opposite to the inner surface of the upper end side housing side portion 32.

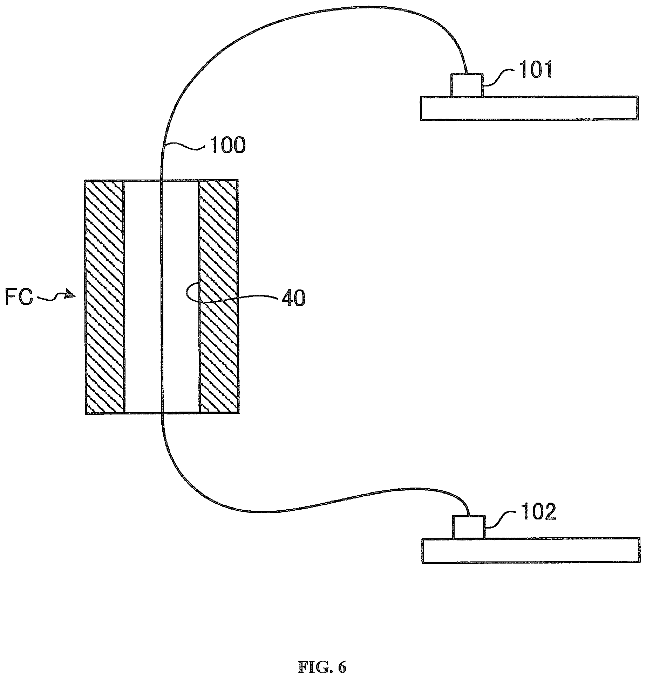

A plurality (in the example shown in the drawings, three) of the ferrite cores FC are housed in this kind of housing recess portion 30. Each ferrite core FC, forming a cylindrical shape, is for achieving a reduction of noise from a wire 100, which connects terminals 101 and 102 configuring the respective control circuits, by the wire 100 being disposed in a manner such as to pass through a hollow portion 40 of the ferrite core FC, as schematically shown in Fig. 6.

A first projecting piece (first projecting portion) 30a projecting leftward is formed on the rear surface side end portion of the housing bottom portion 31 configuring the housing recess portion 30. The first projecting piece 30a can abut against one portion of an annular, rear surface side edge face (one edge face) 41 of the ferrite core FC, and more particularly, can abut against one portion of the rear surface side edge face 41 in a condition in which an opening 41a of the hollow portion 40 at the rear surface side edge face 41 is opened.

A support piece 35 configured from the same quality material (resin material) is formed on the upper end side housing side portion 32 configuring the housing recess portion 30. The support piece 35 is configured by a downward extending portion (first support portion) 351 extending downward from the upper end side housing side portion 32 and a rightward extending portion (second support portion) 352 extending in a direction toward the housing bottom portion 31, that is, rightward from the extension end portion of the downward extending portion 351 being integrally formed.

The extension length of the downward extending portion 351 is shorter than the extension length in the up-down direction of the housing bottom portion 31, and the inner surface of the downward extending portion 351 is opposite to the inner surface of the housing bottom portion 31. The spaced distance between the downward extending portion 351 and the housing bottom portion 31 is adjusted to a size slightly smaller than the outside diameter of the ferrite cores FC.

The inner surface of the rightward extending portion 352 is opposite to the inner surface of the upper end side housing side portion 32. The spaced distance between the rightward extending portion 352 and the upper end side housing side portion 32 is adjusted to a size slightly smaller than a size wherein the outside diameter of the ferrite cores FC is multiplied by the number (in the example shown in the drawings, three) of ferrite cores FC housed.

Also, the second projecting piece (second projecting portion) 35a is formed on the front surface side end portion of the support piece 35. The second projecting piece 35a is formed in a manner such as to project rightward from the front surface side end portion of the downward extending portion 351 of the support piece 35, and the upper end portion of the second projecting piece 35a is connected to the upper end side housing side portion 32, while the lower end portion of the second projecting piece 35a is connected to the rightward extending portion 352.

This kind of second projecting piece 35a can abut against one portion of an annular, front surface side edge face (the other edge face) 42 of the ferrite core FC, and more particularly, can abut against one portion of the front surface side edge face 42 in a condition in which an opening 42a of the hollow portion 40 at the front surface side edge face 42 is opened. That is, the spaced distance in a front-rear direction between the second projecting piece 35a and the first projecting piece 30a coincides with the height of the ferrite core FC.

This kind of support piece 35, as it is configured from a resin material which is the same quality material as that of the power supply case 20, has flexibility such that the support piece 35 can change elastically in shape in directions toward and away from the housing bottom portion 31 with the connection point of the support piece 35 and upper end side housing side portion 32 as a reference.

Consequently, as the spaced distance between the support piece 35 (downward extending portion 351) and the housing bottom portion 31, and the spaced distance between the support piece 35 (rightward extending portion 352) and the upper end side housing side portion 32, increase when the support piece 35 is caused to change elastically in shape in the direction away from the housing bottom portion 31, it is possible to allow the ferrite cores FC to come in or out.

Further, as the support piece 35 is returned to its original state by its resilience when a force acting on the support piece 35 is removed to bring the support piece 35 into a free state, it is possible, when the ferrite core FC is in, to clamp the ferrite core FC between the housing bottom portion 31 and the upper end side housing side portion 32.

As shown in Figs. 4 and 5, the space formed between the support piece 35 and the side cover 15 (left side cover 15) is set to have a size such that the ferrite core FC does not come off from the housing recess portion 30 even when the support piece 35 changes elastically in shape in the direction (leftward) away from the housing bottom portion 31 and abuts against the left side cover 15.

As heretofore described, in the inverter device 1 which is the embodiment, the support piece 35 extending in a manner such as to project from the upper end side housing side portion 32 configuring the housing recess portion 30 clamps the ferrite cores FC between the housing bottom portion 31 and the upper end side housing side portion 32, and the first projecting piece 30a formed in a manner such as to project from the housing bottom portion 31 abuts against one portion of one end edge face of each ferrite core FC, while the second projecting piece 35a formed in a manner such as to project from the support piece 35 abuts against one portion of the other edge face of each ferrite core FC, thereby enabling the ferrite cores FC to be held in a condition in which the movement of the ferrite cores FC in the front-rear direction, the up-down direction, and a left-right direction is restricted. Moreover, as there is no need for a clamping band or the like, as heretofore known, and it is only necessary to utilize the elastic resilience of the support piece 35, it is possible to reduce the number of parts and reduce a mounting man-hour.

Consequently, according to the inverter device 1, by reducing the number of parts and a mounting man-hour, it is possible to achieve a reduction in cost.

Heretofore, a description has been given of a preferred embodiment of the invention, but the invention not being limited to this, it is possible to carry out various modifications.

In the heretofore described embodiment, the housing recess portion 30 which houses the ferrite cores FC is provided in a side portion of the resin power supply case 20, but in the invention, the housing recess portion may be provided in a desired portion appropriate for housing the ferrite cores.

### Reference Signs List

1 Inverter device
10 Frame
11 Rear surface cover
12 Cooling fins
13 Cooling fan
14 Front surface cover
15 Side cover
16 Top plate
17 Bottom plate
20 Power supply case (case body)
21 Power supply printed circuit board
30 Housing recess portion
30a First projecting piece (first projecting portion)
31 Housing bottom portion
32 Upper end side housing side portion
33 Lower end side housing side portion
35 Support piece
35a Second projecting piece (second projecting portion)
351 Downward extending portion (first support portion)
352 Rightward extending portion (second support portion)
40 Hollow portion
41 Rear surface side edge face (one edge face)
41a Opening
42 Front surface side edge face (the other edge face)
42a Opening
FC Ferrite core

## Claims

1. An inverter device (1) which includes a cylindrical ferrite core (FC), disposed in a manner such that a wire (100) passes through a hollow portion (40) of the ferrite core, in a condition in which the ferrite core is housed in a housing recess portion (30) of a case body (20), the inverter device being **characterized by** including:
a support piece (35), extending in a manner such as to project from one housing side portion configuring the housing recess portion, which, with its own elastic resilience, supports the ferrite core between a housing bottom portion configuring the housing recess portion and the housing side portion;
a first projecting portion (30a), formed in a manner such as to project from the housing bottom portion (31), which abuts against one portion of one edge face of the ferrite core; and
a second projecting portion (35a), formed in a manner such as to project from the support piece (35), which abuts against one portion of the other edge face of the ferrite core.

2. The inverter device according to claim 1, **characterized in that** the support piece includes:
a first support portion extending from the housing side portion in an extension direction of the housing bottom portion; and
a second support portion extending from the extension end portion of the first support portion in a direction toward the housing bottom portion.

3. The inverter device according to claim 2, **characterized in that** the first projecting portion is formed throughout a portion in the extension direction of the housing bottom portion, and abuts against one portion of one edge portion of the ferrite core in a condition in which an opening of the hollow portion at the one edge portion is opened.

4. The inverter device according to claim 3, **characterized in that** the second projecting portion is formed throughout a portion in an extension direction of the first support portion, and abuts against one portion of the other edge portion of the ferrite core in a condition in which an opening of the hollow portion at the other edge portion is opened.

## Patentansprüche

1. Umrichtervorrichtung (1), die einen zylinderförmigen Ferritkern (FC) beinhaltet, der derart angeordnet ist, dass in einem Zustand, in dem der Ferritkern in einem Einhausungsvertiefungsabschnitt (30) eines Gehäusekörpers (20) untergebracht ist, ein Draht (100) durch einen hohlen Abschnitt (40) des Ferritkerns verläuft, wobei die Umrichtervorrichtung **dadurch gekennzeichnet ist, dass** sie Folgendes beinhaltet:
ein Haltestück (35), das sich derart erstreckt, dass es aus einem Seitenabschnitt der Einhausung hervorsteht, welcher den Einhausungsvertiefungsabschnitt bildet, und das mit seiner eigenen elastischen Spannkraft den Ferritkern zwischen einem Einhausungsbodenabschnitt, der den Einhausungsvertiefungsabschnitt bildet, und dem Einhausungsseitenabschnitt hält,
einen ersten hervorstehenden Abschnitt (30a), der derart gebildet ist, dass er aus dem Einhausungsbodenabschnitt (31) hervorsteht, das an einem Abschnitt einer Randfläche des Ferritkerns anliegt, und
einen zweiten hervorstehenden Abschnitt (35a), der derart gebildet ist, dass er aus dem Haltestück (35) hervorsteht, das an einem Abschnitt der anderen Randfläche des Ferritkerns anliegt.

2. Umrichtervorrichtung nach Anspruch 1, **dadurch gekennzeichnet, dass** das Haltestück Folgendes beinhaltet:
einen ersten Halteabschnitt, der sich vom Einhausungsseitenabschnitt in einer Erstreckungsrichtung des Gehäusebodenabschnitts erstreckt, und
einen zweiten Halteabschnitt, der sich vom Erstreckungsendabschnitt des ersten Halteabschnitts in eine Richtung zum Gehäusebodenabschnitt hin erstreckt.

3. Umrichtervorrichtung nach Anspruch 2, **dadurch gekennzeichnet, dass** der erste hervorstehende Abschnitt über einen gesamten Abschnitt in der Erstreckungsrichtung des Einhausungsbodenabschnitts gebildet ist und in einem Zustand, in dem eine Öffnung des hohlen Abschnitts an dem einen Randabschnitt offen ist, an einem Abschnitt eines Randabschnitts des Ferritkerns anliegt.

4. Umrichtervorrichtung nach Anspruch 3, **dadurch gekennzeichnet, dass** der zweite hervorstehende Abschnitt über einen gesamten Abschnitt in einer Erstreckungsrichtung des ersten Halteabschnitts gebildet ist und in einem Zustand, in dem eine Öffnung des hohlen Abschnitts am anderen Randabschnitt offen ist, an einem Abschnitt des anderen Randabschnitts des Ferritkerns anliegt.

## Revendications

1. Dispositif onduleur (1) qui comprend un noyau en ferrite cylindrique (FC), disposé de sorte qu'un fil (100) passe à travers une partie creuse (40) du noyau en ferrite, dans une condition dans laquelle le noyau en ferrite est logé dans une partie d'évidement de logement (30) d'un corps de boîtier (20), le dispositif onduleur étant **caractérisé en ce qu'**il comprend :
une pièce de support (35) s'étendant afin de faire saillie d'une partie latérale de logement configurant la partie d'évidement de logement qui, avec sa propre résilience élastique, supporte le noyau en ferrite entre une partie inférieure de logement configurant la partie d'évidement de logement et la partie latérale de logement ;
une première partie en saillie (30a) formée afin de faire saillie de la partie inférieure de logement (31), qui vient en butée contre une partie d'une face de bord du noyau en ferrite ; et
une seconde partie en saillie (35a) formée de sorte qu'elle fait saillie de la pièce de support (35), qui vient en butée contre une partie de l'autre face de bord du noyau en ferrite.

2. Dispositif onduleur selon la revendication 1, **caractérisé en ce que** :
la pièce de support comprend :
une première partie de support s'étendant à partir de la partie latérale de logement dans une direction d'extension de la partie inférieure de logement ; et
une seconde partie de support s'étendant à partir de la partie d'extrémité d'extension de la première partie de support dans une direction vers la partie inférieure de logement.

3. Dispositif onduleur selon la revendication 2, **caractérisé en ce que** :
la première partie en saillie est formée sur toute une partie dans la direction d'extension de la partie inférieure de logement, et vient en butée contre une partie d'une partie de bord du noyau en ferrite dans une condition dans laquelle une ouverture de la partie creuse au niveau de la une partie de bord, est ouverte.

4. Dispositif onduleur selon la revendication 3, **caractérisé en ce que** :
la seconde partie en saillie est formée sur toute une partie dans une direction d'extension de la première partie de support, et vient en butée contre une partie de l'autre partie de bord du noyau en ferrite dans une condition dans laquelle une ouverture de la partie creuse, au niveau de l'autre partie de bord, est ouverte.
